(19) **Europäisches Patentamt / European Patent Office / Office européen des brevets**

(11) **EP 4 394 458 A1**

(12) **EUROPEAN PATENT APPLICATION**
published in accordance with Art. 153(4) EPC

(43) Date of publication:
**03.07.2024 Bulletin 2024/27**

(21) Application number: **22861275.0**

(22) Date of filing: **19.08.2022**

(51) International Patent Classification (IPC):
**G02B 3/00** (2006.01)    **F21V 5/00** (2018.01)
**F21V 5/04** (2006.01)    **F21V 13/02** (2006.01)
**F21V 14/00** (2018.01)    **G01S 7/481** (2006.01)
**H01S 5/022** (2021.01)    **F21Y 115/30** (2016.01)

(52) Cooperative Patent Classification (CPC):
**F21V 5/00; F21V 5/04; F21V 13/02; F21V 14/00; G01S 7/481; G02B 3/00; H01S 5/022;** F21Y 2115/30

(86) International application number:
**PCT/JP2022/031411**

(87) International publication number:
**WO 2023/026987 (02.03.2023 Gazette 2023/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.08.2021  JP 2021137560**

(71) Applicant: **Scivax Corporation Kawasaki-shi, Kanagawa 212-0032 (JP)**

(72) Inventors:
• **NAWATA, Akifumi Kawasaki-shi Kanagawa 212-0032 (JP)**
• **NAKAMURA, Tomonori Kawasaki-shi Kanagawa 212-0032 (JP)**
• **TANAKA, Satoru Kawasaki-shi Kanagawa 212-0032 (JP)**

(74) Representative: **Grättinger Möhring von Poschinger Patentanwälte Partnerschaft mbB Wittelsbacherstrasse 2b 82319 Starnberg (DE)**

(54) **OPTICAL SYSTEM DEVICE**

(57)    According to an optical system device that has a diffraction grating replaced with a microlens, the contrast of a dot pattern is low. An objective is to provide an optical system device including an optical element 2 including a plurality of lenses 21 through which light with a wavelength λ passes and which is arranged periodically, and an emitting unit 1 including a light source 10 emitting the light with the wavelength λ to the plurality of lenses 21, in which, when a focal distance of the lens 21 is defined as f, n is defined as a natural number equal to or greater than one, and a dimension of a k-th pitch (where k is a natural number equal to or greater than one) from the smallest pitch among the pitches of the lenses 21 is defined as $P_k$, for equal to or greater than any one pitch $P_k$, a distance $L_1$ between the emitting unit 1 and a focal point position 9 of the optical element 2 satisfies the following formula 1.
[Mathematical Expression 1]

$$\frac{n P_k^2}{2\lambda} - f < L_1 < \frac{n P_k^2}{2\lambda} + f \qquad \text{Formula 1}$$

**(Cont. next page)**

FIG. 1

**Description**

TECHNICAL FIELD

The present disclosure relates to an optical system device.

BACKGROUND ART

Three-dimensional measurement sensors that utilize a Time Of Flight (TOF) scheme are now to be applied to portable devices, vehicles, and robots, etc. such a sensor measures a distance from an object based on a time until light emitted by a light source to an object is reflected and returns. When light from the light source is emitted uniformly to the predetermined region of the object, the distance at each point subjected to light emission can be measured, and thus the three-dimensional structure of the object can be detected.

The above-described sensor system includes a light emitting unit that emits light to an object, a camera unit that detects reflected light from each point of the object, and an arithmetic unit that calculates a distance from the object in accordance with a signal according to the light received by the camera unit.

As for the camera unit and the arithmetic unit, already-existing CMOS imager and CPU are applicable, respectively, and thus the unique component of the above-described system is the light emitting unit that includes a laser and an optical filter. In particular, the distinguishing component of the above-described system is a diffusing filter which shapes a beam by causing laser light to pass through a microlens array, and which cause light to be emitted uniformly within a controlled region to an object.

Conventional diffusing filters have a technical problem such that the variability occurs in light intensity due to the adverse effect of diffraction since the microlens array employs a periodic structure. Hence, in order to suppress such a variability, an attempt such as to place each lens at random is made (e.g., Patent Document 1).

Conversely, the TOF has needs for long-distance measurement, and emitted light needs an intensity that enables such a long-distance measurement. However, since the microlens array having undergone the random placement has the high uniformity of emitted light but decreases the intensity thereof, it is not suitable for such a long-distance measurement.

Hence, as for a scheme capable of processing intensive light signal while saving electric power, a scheme to emit a dot pattern and to execute a three-dimensional measurement from the Time Of Flight of such light is now examined.

Conventionally, an optical system device that converts incident light into a dot pattern by utilizing the Lau effect is known (e.g., Non-patent Document 1). This includes a diffraction grating with a predetermined pitch P, and a light source, and when the wavelength of light from the light source is defined as $\lambda$, and n is a natural number that is equal to or greater than 1, placement is made in such a way that a distance $L_0$ between the diffraction grating and the light source satisfies the following formula A.

[Mathematical Expression 1]

$$L_0 = \frac{n\,P^2}{2\lambda} \qquad\qquad \text{Formula A}$$

Moreover, replacement of the diffraction grating with a microlens is now also examined (e.g., Patent Document 2).

CITATION LIST

PATENT LITERATURES

Patent Document 1: JP 2006-500621A

Patent Document 2: WO 2017/131585A

Non-patent Document 1: H. Hamam, Lau Array Illuminator, Applied Optics, 43(14): 2888-2894, May 10, 2004.

## SUMMARY OF INVENTION

### TECHNICAL PROBLEM

However, replacement of the diffraction grating with a microlens has a technical disadvantage such that the contrast of the dot pattern decreases.

Hence, an objective of the present disclosure is to provide an optical system device capable of emitting light with a high contrast. Conversely, another objective is to provide an optical system device that can be utilized as a diffuser which is to emit uniform light.

### SOLUTION TO PROBLEM

In order to accomplish the above objectives, an optical system device according to the present disclosure includes:

an optical element that includes a plurality of lenses through which light with a wavelength $\lambda$ passes and which is arranged periodically; and

an emitting unit that includes a light source which emits the light with the wavelength $\lambda$ to the plurality of lenses,

in which when a focal distance of the lens is defined as f, n is defined as a natural number that is equal to or greater than one, and a dimension of a k-th pitch (where k is a natural number that is equal to or greater than one) from the smallest pitch among the pitches of the lenses is defined as $P_k$, for equal to or greater than any one pitch $P_k$, a distance $L_1$ between the emitting unit and a focal point position of the optical element satisfies the following formula 1.
[Mathematical Expression 2]

$$\frac{n P_k^2}{2\lambda} - f < L_1 < \frac{n P_k^2}{2\lambda} + f \qquad \text{Formula 1}$$

In this case, it is preferable that the distance $L_1$ should satisfy the following formula 2.
[Mathematical Expression 3]

$$L_1 = \frac{n P_k^2}{2\lambda} \qquad \text{Formula 2}$$

It is preferable that the formula 1 should be satisfied for the smallest pitch $P_1$, and the formula 1 should be satisfied for the second smallest pitch $P_2$.

Moreover, another optical system device according to the present disclosure includes:

an optical element that includes a plurality of lenses through which light with a wavelength $\lambda$ passes and which is arranged periodically; and

an emitting unit that includes a light source which emits the light with the wavelength $\lambda$ to the plurality of lenses,

in which when a focal distance of the lens is defined as f, n is defined as a natural number that is equal to or greater than one, and a dimension of a k-th pitch (where k is a natural number that is equal to or greater than one) from the smallest pitch among the pitches of the lenses is defined as $P_k$, for equal to or greater than any one pitch $P_k$, a distance $L_2$ between the emitting unit and a focal point position of the optical element satisfies the following formula $\alpha$.
[Mathematical Expression 4]

$$\frac{(n-1) P_k^2}{2\lambda} + f < L_2 < \frac{n P_k^2}{2\lambda} - f \qquad \text{Formula } \alpha$$

Moreover, it is preferable that the above-described optical system device should further include distance adjusting means for adjusting a distance between the optical element and the emitting unit.

ADVANTAGEOUS EFFECTS OF INVENTION

The optical system device according to the present disclosure can emit light with a high contrast.

BRIEF DESCRIPTION OF DRAWINGS

FIG.1 is a schematic cross-sectional view illustrating an optical system device according to the present disclosure;

FIG.2 is a diagram illustrating a light intensity at a far field for each light emitting mode;

FIG.3 is a diagram illustrating a light intensity at a far field for each classified and synthesized light emitting mode;

FIG.4 is a diagram illustrating a light intensity at a far field of light synthesized by changing a ratio for each light emitting mode;

FIG.5 is a schematic plan view illustrating an optical element according to the present disclosure;

FIG.6 is a schematic cross-sectional view illustrating a conventional optical system device;

FIG.7 is a diagram illustrating a distributed light distribution at a far field of an emitting unit applied for a simulation;

FIG.8 is a diagram illustrating the way of the propagation of light from a lens applied for a first simulation;

FIG.9 is a diagram illustrating optical characteristics based on the first simulation (focal distance: 20 $\mu$m);

FIG.10 is a diagram illustrating the optical characteristics based on the first simulation (focal distance: 40 $\mu$m);

FIG.11 is a diagram illustrating the optical characteristics based on the first simulation (focal distance: 60 $\mu$m);

FIG.12 is a diagram illustrating an appearance of light when collimated light is caused to enter a lens (focal distance: 20 $\mu$m) applied for a second simulation;

FIG.13 is a diagram illustrating an appearance of light when collimated light is caused to enter a lens (focal distance: 40 $\mu$m) applied for the second simulation;

FIG.14 is a diagram illustrating an appearance of light when collimated light is caused to enter a lens (focal distance: 60 $\mu$m) applied for the second simulation;

FIG. 15 is a projection drawing in accordance with a difference in $\delta$ in the second simulation (focal distance: 20 $\mu$m);

FIG. 16 is a projection drawing in accordance with a difference in $\delta$ in the second simulation (focal distance: 40 $\mu$m);

FIG. 17 is a projection drawing in accordance with a difference in $\delta$ in the second simulation (focal distance: 60 $\mu$m);

FIG. 18 illustrates a distributed light distribution in accordance with a difference in $\delta$ in the second simulation (focal distance: 20 $\mu$m);

FIG. 19 illustrates a distributed light distribution in accordance with a difference in $\delta$ in the second simulation (focal distance: 40 $\mu$m);

FIG. 20 illustrates a distributed light distribution in accordance with a difference in $\delta$ in the second simulation (focal distance: 60 $\mu$m);

FIG. 21 is a diagram illustrating the maximum light intensity in accordance with a difference in $\delta$ in the second simulation (focal distance: 20 $\mu$m);

FIG. 22 is a diagram illustrating the maximum light intensity in accordance with a difference in $\delta$ in the second simulation (focal distance: 40 $\mu$m);

FIG. 23 is a diagram illustrating the maximum light intensity in accordance with a difference in $\delta$ in the second simulation (focal distance: 60 $\mu$m);

FIG. 24 is a diagram to describe a lens according to the present disclosure;

FIG. 25 is a diagram illustrating an appearance of light when collimated light is caused to enter a lens applied for a third simulation.

FIG. 26 is a projection drawing in accordance with a difference in $\delta$ in the third simulation (focal distance: 20 $\mu$m);

FIG. 27 illustrates a distributed light distribution (x-axis direction) in accordance with a difference in $\delta$ in the third simulation;

FIG. 28 illustrates a distributed light distribution (y-axis direction) in accordance with a difference in $\mu$ in the third simulation;

FIG.29 is a diagram illustrating the maximum light intensity in accordance with a difference in $\delta$ in the third simulation;

FIG.30 is a schematic plan view illustrating a positional relation between an emitting unit and an optical element according to the present disclosure;

FIG.31 is a schematic cross-sectional view illustrating another optical system device according to the present disclosure;

FIG. 32 is a schematic cross-sectional view illustrating an optical system device as a diffuser according to the present disclosure; and

FIG.33 is a schematic cross-sectional view illustrating an optical system device that includes position adjusting means according to the present disclosure.

## DESCRIPTION OF EMBODIMENTS

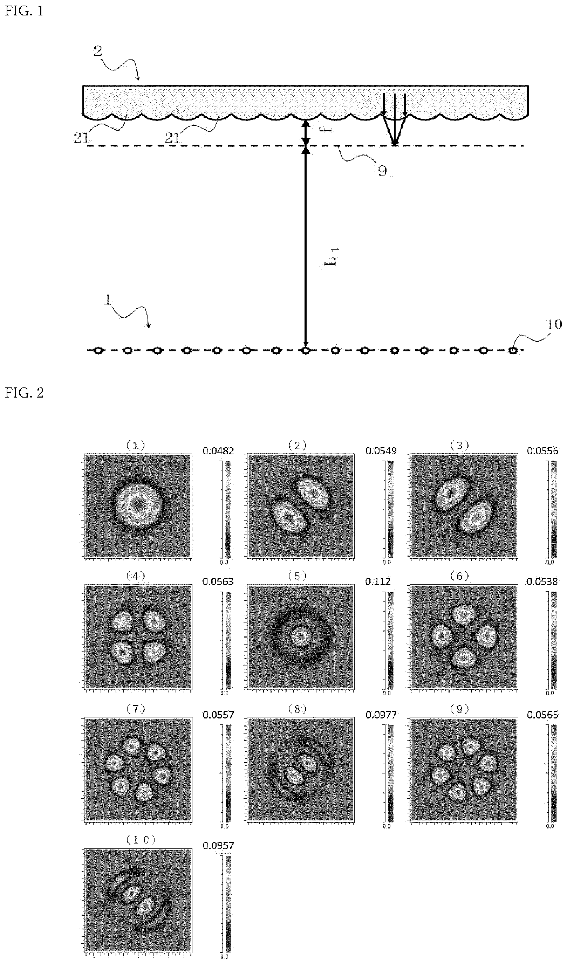

An optical system device according to the present disclosure will be described below. As illustrated in FIG. 1, the optical system device of the present disclosure mainly includes an emitting unit 1 that emits light with a wavelength $\lambda$, and an optical element 2 that includes periodic lenses 21.

The emitting unit 1 is not limited to any particular component as far as it includes a light source that emits light with a wavelength $\lambda$ to the plurality of lenses 21. Moreover, the emitting unit 1 may include a singular light source or a plurality of light sources. Furthermore, light from a singular light source may be caused to pass through an aperture with multiple pores so as to accomplish a function as a plurality of light sources. When the emitting unit is formed by a plurality of light sources, it is preferable that such light sources should be formed on the same plane. A specific example of the emitting unit 1 is a Vertical Cavity Surface Emitting LASER (VCSEL) that is expected to achieve a high output with merely low electric power. The VCSEL includes a plurality of light sources 10 capable of emitting lights in the vertical direction to a light emitting surface. Moreover, it is preferable that a light absorption film should be formed on a portion other than the light source since it can prevent noises due to reflected light from entering therein.

[light Emitting Mode]

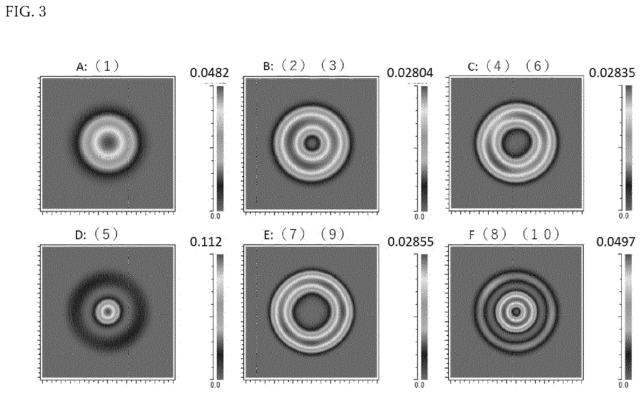

Moreover, when the light intensity of the VCSEL is to be increased, it is known that light from the VCSEL includes a plurality of light emitting modes, such as a single mode and a multi-mode. Specific example light emitting modes are illustrated in FIG. 2. In the light emitting modes illustrated in FIG. 2, (2) and (3), (4) and (6), (7) and (9), and (8) and (10) which are rotationally symmetric to each other, respectively, are always present at the same percentage, and when those similar modes are synthesized, respectively, as illustrated in FIG. 3, those can be consolidated into six kinds that are A, B, C, D, E, and F.

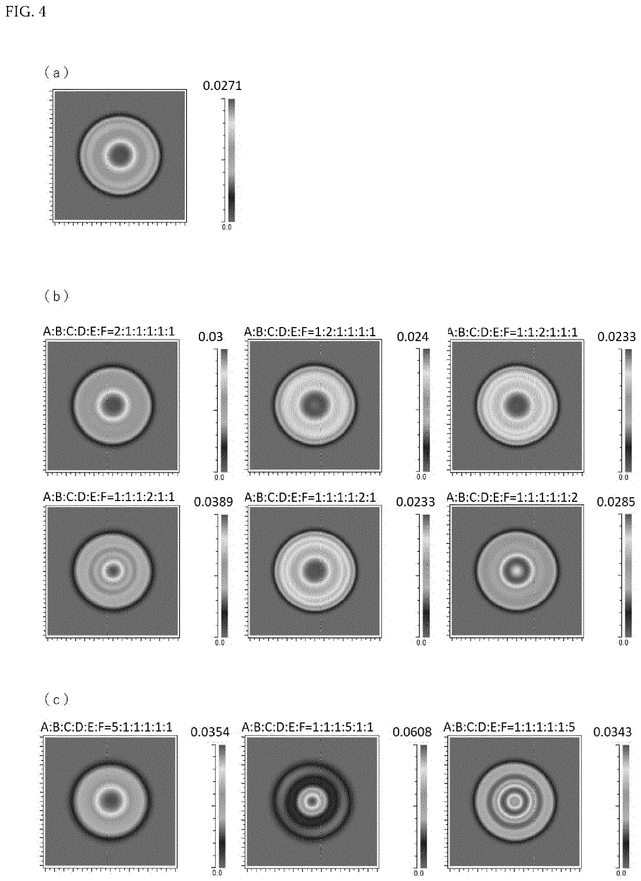

When these six kinds of modes are synthesized at the same ratio (A:B:C:D:E:F = 1:1:1:1:1:1), it becomes as illustrated in part (a) of FIG. 4, and the maximum intensity becomes 0.0271. Note that the figure illustrates the light intensity at a far field in each light distribution angle when the power of the light source is defined as 1.

Conversely, when only one kind among those six kinds is made twice as much as the other modes and those are synthesized, as illustrated in part (b) of FIG. 4, A:B:C:D:E:F = 2:1:1:1:1:1 has the maximum intensity that is 0.03, A:B:C:D:E:F = 1:1:1:2:1:1 has the maximum intensity that is 0.0389, and A:B:C:D:E:F = 1:1:1:1:1:2 has the maximum intensity that is 0.0285. That is, it becomes clear that, among the respective modes, when the ratio of the mode A or D that has the maximum intensity at the optical axis center, or the mode F that has the maximum intensity near the optical axis center increases, the maximum intensity of light having undergone synthesis becomes large in comparison with a case in which six kinds of the modes are set to be the same ratio. Part (c) of FIG. 4 illustrates results when, among six kinds of the modes, only the mode A, the mode D, and the mode F are further made five times as much as the other modes and those are synthesized. A:B:C:D:E:F = 5:1:1:1:1:1 has the maximum intensity that is 0.0354, A:B:C:D:E:F = 1:1:1:5:1:1 has the maximum intensity that is 0.0608, and A:B:C:D:E:F = 1:1:1:1:1:5 has the maximum intensity that is 0.0343. That is, light synthesized with the mode D being made five times (A:B:C:D:E:F = 1:1:1:5:1:1) has the maximum intensity of light remarkably increased after the synthesis.

In view of the above results, when the VCSEL that has the plurality of light emitting modes is applied, it is preferable that the light source of the VCSEL should have the greater ratio of the light emitting mode which has the maximum intensity at the optical axis center among the plurality of light emitting modes since the light intensity of a dot to be produced increases and the contrast can be also increased. Hence, it is preferable that the ratio of the mode having the maximum intensity at the optical axis center among the light emitting modes of the light source should be equal to or greater than 40 %, more preferably, equal to or greater than 45 %, and further preferably, equal to or greater than 60 %. Such a light emitting mode may be adjusted by conventionally known schemes like controlling the current injection path of the light emitting layer of the VCSEL.

The optical element 2 has the lenses 21 which allow light with a wavelength $\lambda$ to pass through, and which are arranged periodically. The lens 21 has a focal point at a position apart from the lens 21 by a predetermined distance f (where f > 0). According to the optical element of the present disclosure, the greater the focal distance f is, such as equal to or greater than 10 $\mu$m, equal to or greater than 20 $\mu$m, equal to or greater than 40 $\mu$m, and equal to or greater than 60 $\mu$m, the more the contrast can be improved in comparison with conventional technologies.

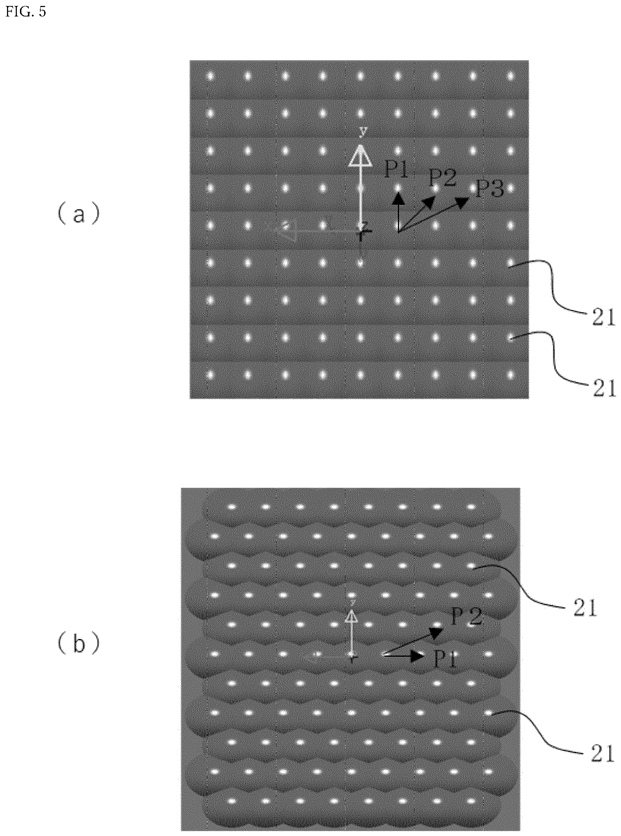

The shape of the lens 21 can be designed freely in accordance with the desired spreading pattern of dot to be emitted (will be referred to as a dot pattern below). When, for example, a circular dot pattern is desired, the shape of the lens 21 may be designed as a spherical lens. Moreover, when a non-circular dot pattern is desired, the shape of the lens 21 may be designed as appropriate so as to accomplish an aspheric lens. Specific example lens shapes are a convex lens, a concave lens, and a saddle-type lens that looks like as if a convex lens or a concave lens depending on a cross-section. Furthermore, as for the periodical arrangement, square or rectangular lenses 21 in a planar view are arranged tetragonally as illustrated in part (a) of FIG. 5, and hexagonal lenses 21 in a planar view are arranged hexagonally as illustrated in part (b) of FIG. 5. Still further, the lens 21 is not limited to any particular lens as far as it can function as a lens, and for example, a Fresnel lens, a DOE lens, and a meta-lens, etc., can be also applied. Yet still further, it is preferable that an antireflection film that prevents light from the emitting unit from being reflected should be formed on the lens 21.

The emitting unit 1 and the optical element 2 are placed in such a way that the optical-axis direction of the light source of the emitting unit 1 and the optical-axis direction of the lens 21 of the optical element 2 are consistent with each other.

[Positional Relation between Emitting unit and Optical Element]

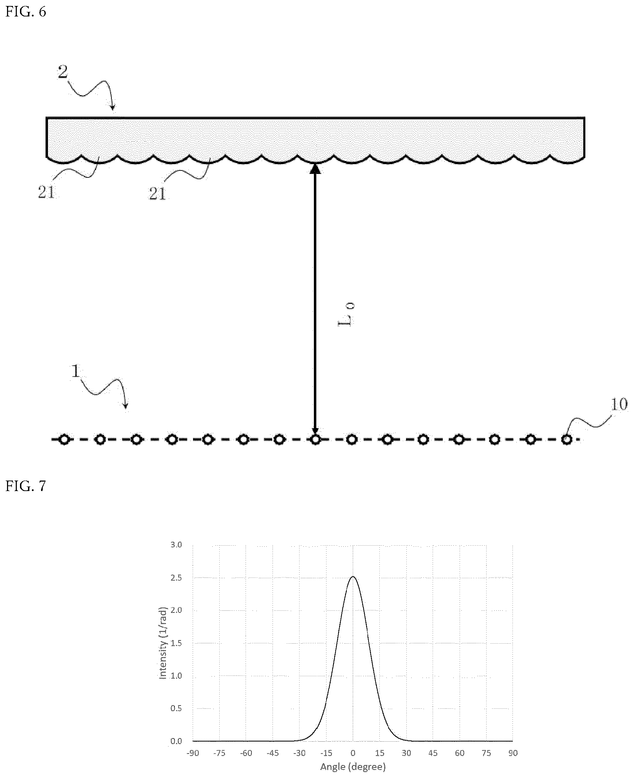

Conventionally, when n is defined as a natural number that is equal to or greater than 1, the wavelength of incident light from the emitting unit 1 is defined as $\lambda$, the pitch of the lenses 21 of the optical element 2 is defined as P, and the distance between the emitting unit 1 and the optical element 2 is defined as $L_0$, it has been thought that incident light can be converted into a dot pattern with a large contrast when the distance $L_0$ satisfies the following formula (see FIG. 6).

[Mathematical Expression 5]

$$L_0 = \frac{n P^2}{2\lambda} \qquad \text{Formula A}$$

However, upon keen examinations and researches by the inventors of the present disclosure, it becomes clear that, when the focal distance of the optical element is defined as f, lights are further intensified and a dot pattern with a large contrast can be produced when the distance $L_0$ satisfies the following formula B.
[Mathematical Expression 6]

$$\frac{n\,P^2}{2\lambda} < L_0 < \frac{n\,P^2}{2\lambda} + 2\,f \qquad \text{Formula B}$$

In particular, it becomes clear that, when the following formula C is satisfied, lights are maximally intensified.
[Mathematical Expression 7]

$$L_0 = \frac{n\,P^2}{2\lambda} + f \qquad \text{Formula C}$$

When the formula B and the formula C are represented not by the distance $L_0$ between the emitting unit 1 and the optical element 2, but by a distance $L_1$ between the emitting unit 1 and a focal point position 9 of the optical element 2 as illustrated in FIG. 1 ($L_1 = L_0 - f$), those formulae become the following formulae D and E.
[Mathematical Expression 8]

$$\frac{n\,P^2}{2\lambda} - f < L_1 < \frac{n\,P^2}{2\lambda} + f \qquad \text{Formula D}$$

[Mathematical Expression 9]

$$L_1 = \frac{n\,P^2}{2\lambda} \qquad \text{Formula E}$$

Moreover, the lens 21 may have plural kinds of period. When, for example, the square lenses 21 in a planar view are arranged tetragonally as illustrated in part (a) of FIG. 5, in addition to a pitch $P_1$ between the adjacent lenses to each other, there are various kinds of pitches, such as a pitch $P_2$ (= $\sqrt{2}P_1$) and a pitch $P_3$ (= $\sqrt{5}P_1$) in the diagonal direction. Furthermore, when the hexagonal lenses 21 in a planar view are arranged hexagonally as illustrated in part (b) of FIG. 5, in addition to the pitch $P_1$ between the adjacent lenses to each other, there are pitches like the pitch $P_2$ (= $\sqrt{3}P_1$). Still further, like a case in which rectangular lenses in a planar view are arranged regularly, the lens 21 may have plural different periods. In this case, when the dimension of a k-th (where k is a natural number equal to or greater than 1) pitch from the smallest one among the pitches of the lens 21 is defined as $P_k$, and coefficients are defined as a (a ≤ 1) and b (b ≤ 1), for equal to or greater than any one pitch $P_k$, it is appropriate that the distance $L_1$ between the emitting unit and the focal point position 9 of the optical element should satisfy the following formula F.
[Mathematical Expression 10]

$$\frac{n\,P_k^2}{2\lambda} - a\,f < L_1 < \frac{n\,P_k^2}{2\lambda} + b\,f \qquad (\text{Formula F})$$

In this case, it is preferable that the coefficients of the formula F should be as small as possible, such as a = 1, a = 0.5, a = 0.3, and a = 0.1. Moreover, it is preferable that the coefficient b should as small as possible, such as b = 1, b = 0.5, b = 0.3, and b = 0.1. When the coefficients of the formula F are a = 1 and b = 1, the formula F becomes the following formula 1.
[Mathematical Expression 11]

$$\frac{n\,P_k^{\,2}}{2\lambda} - f < L_1 < \frac{n\,P_k^{\,2}}{2\lambda} + f \qquad\qquad \text{Formula 1}$$

Moreover, it is the most preferable that the distance $L_1$ should satisfy the following formula 2 where a = b = 0.
[Mathematical Expression 12]

$$L_1 = \frac{n\,P_k^{\,2}}{2\lambda} \qquad\qquad \text{Formula 2}$$

Note that it is preferable that, for equal to or greater than any two pitches $P_k$, the distance $L_1$ between the emitting unit 1 and the focal point position 9 of the optical element 2 should be adjusted so as to satisfy the formula 1. In that case, since the diffraction has the maximum effect when the pitch is the smallest, it is preferable to satisfy the formula 1 for the smallest pitch $P_1$, and more preferably, to satisfy the formula 1 for the second smallest pitch $P_2$.
Note that, when the pitch $P_k$ becomes too smaller than the wavelength $\lambda$ of the light from the light source 10, it becomes difficult to produce diffraction. Hence, it is preferable that the $P_k$, in particular, the pitch $P_1$ should be sufficiently larger than the wavelength $\lambda$ of the light from the light source 10 as far as the sufficient lenses 21 to produce the diffraction within a light distribution angle of the light source 10 are provided, and for example, equal to or greater than five times, more preferably, equal to or greater than 10 times are suitable.

[Simulations]

Next, with the distance $L_1$ between the emitting unit 1 and the focal point position 9 of the optical element 2 being set as the following formula 3, simulations were made for light intensity distributions at a far field when $\delta$ was changed variously.
[Mathematical Expression 13]

$$L_1 = \frac{n\,P_k^{\,2}}{2\lambda} + \delta \qquad\qquad \text{Formula 3}$$

[First Simulation]

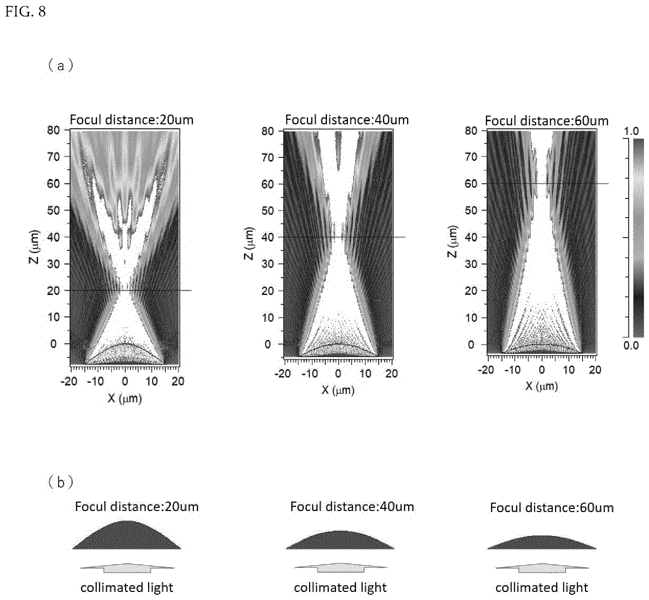

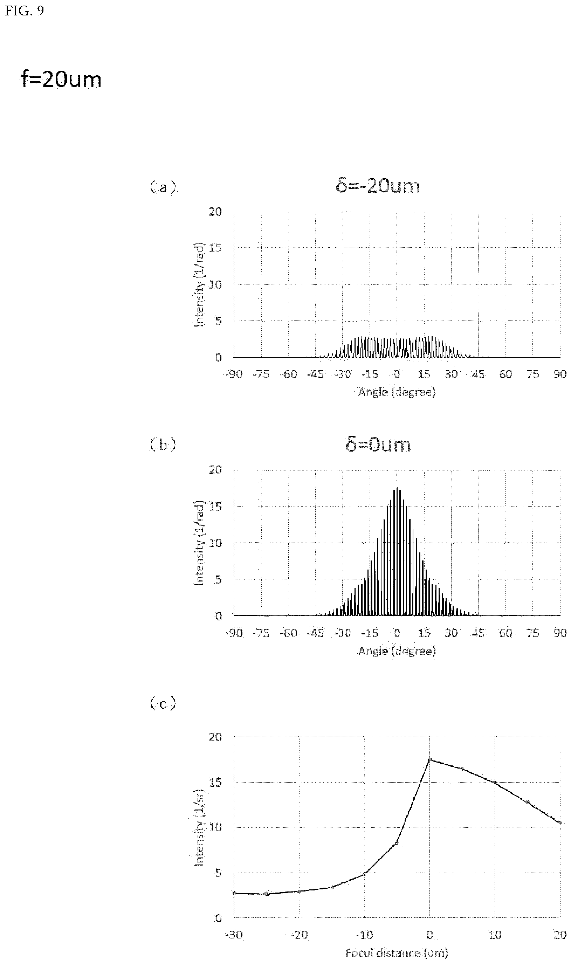

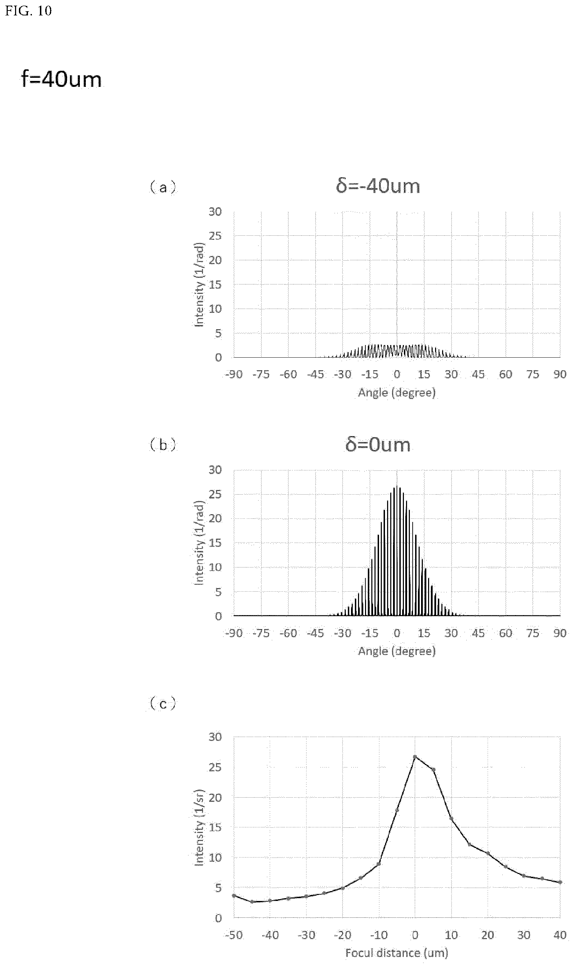

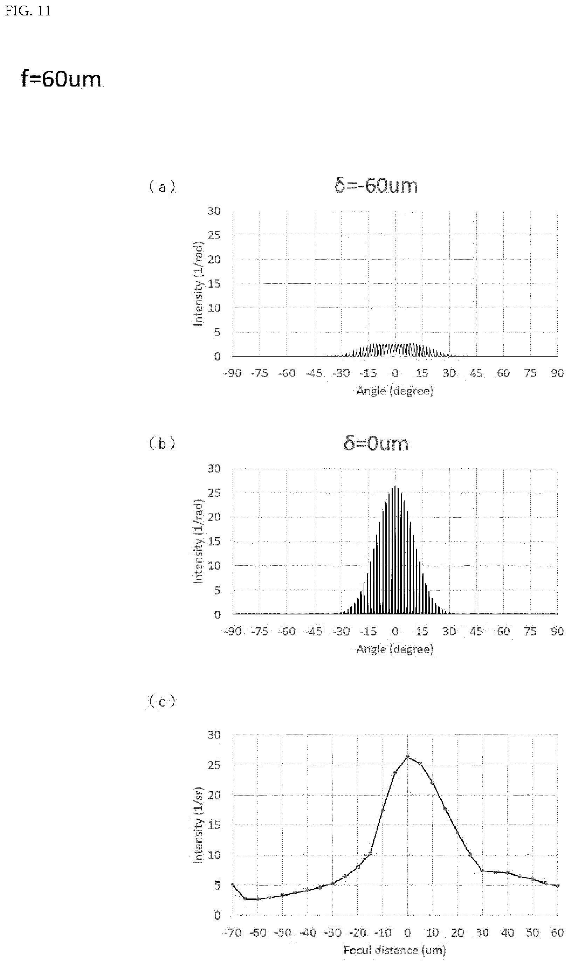

The emitting unit 1 was a singular light source that emits light which has a wavelength of 940 nm ($\lambda$ = 0.94) and which is Gaussian distributed light as illustrated in FIG. 7. The applied optical element 2 had the plurality of lenses 21 arranged periodically in such a way that the pitch $P_1$ becomes 30 $\mu$m ($P_1$ = 30) as illustrated in FIG. 1. Moreover, three kinds of the lens 21 were applied which have a diameter that is 30 $\mu$m, a refractive index that is 1.5, and focal distances f that are (a) 20 $\mu$m, (b) 40 $\mu$m, and (c) 60 $\mu$m. Part (a) of FIG.8 is a diagram illustrating the way of the propagation of light when collimated light was emitted to each lens as illustrated in part (b) of FIG. 8. Note that n in the formula 3 was set to be 2. FIGS. 9 to 11 illustrate simulation results using an optical simulation software BeamPROP (available from Synopsys Inc.). Such a simulation was a 2D calculation result that has the depthwise direction in FIG. 2 not taken into consideration in order to simplify the calculation.
Respective parts (a) of FIG. 9 to FIG. 11 are each a graph showing a light intensity distribution when the distance $L_0$ between the emitting unit 1 and the optical element 2 satisfies the formula A like conventional technologies. Moreover, respective parts (b) of FIG. 9 to FIG. 11 are each a graph showing a light intensity distribution when the distance $L_1$ between the emitting unit 1 and the focal point position 9 of the optical element 2 satisfies the formula 2. Furthermore, respective parts (c) of FIG. 9 to FIG. 11 are each a graph showing a difference of the maximum light intensity in each light intensity distribution relative to the value of $\delta$. Note that the horizontal axis in respective parts (a) and (b) of FIG. 9 to FIG. 11 represents a light distribution angle, and the vertical axis therein represents a light intensity at a far field when the power of the light source is defined as 1. Moreover, the horizontal axis in respective parts (c) of FIG. 9 to FIG. 11 represents $\delta$, and the vertical axis therein represents a light intensity at a far field when the power of the light source is defined as 1.
In view of the simulation results, it becomes clear that the optical element 2 that satisfies the formula 1 has a clear peak in comparison with a case in which the formula A is satisfied. Moreover, it also becomes clear that, when the formula 2 is satisfied, the light intensity at the peak becomes the maximum.

[Second Simulation]

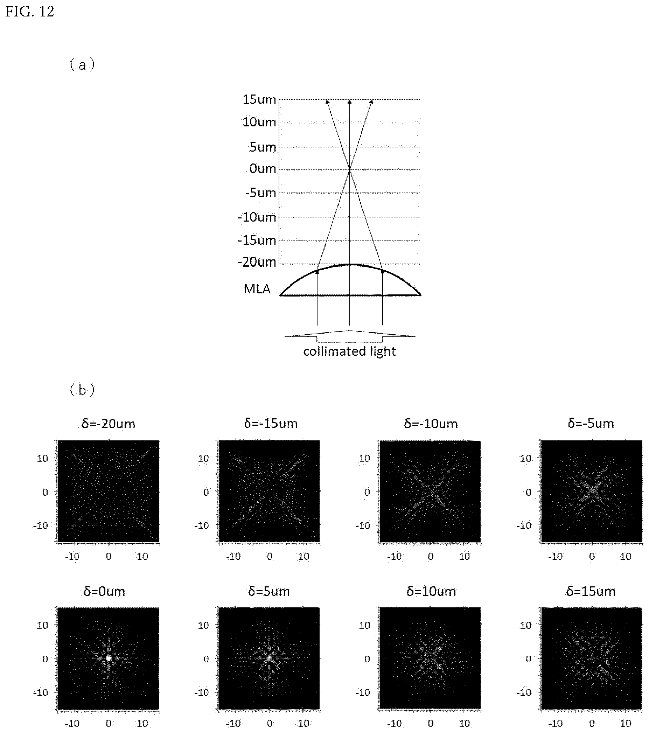

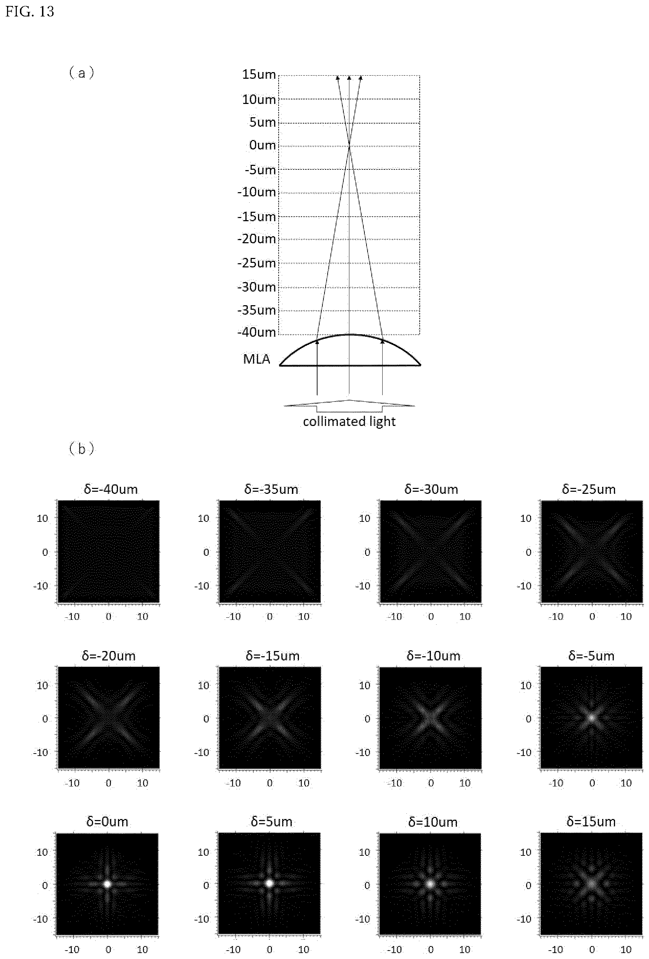

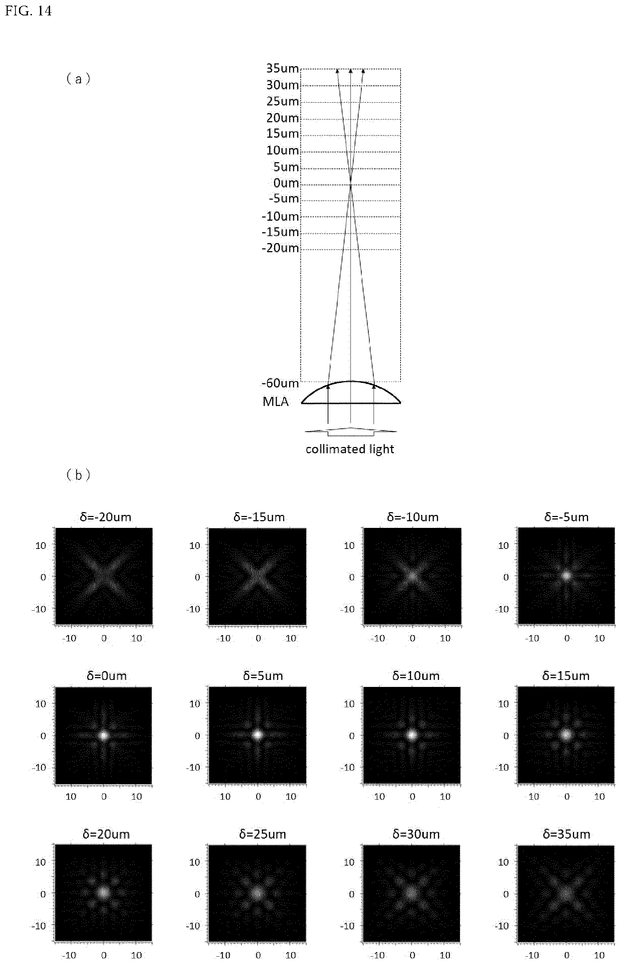

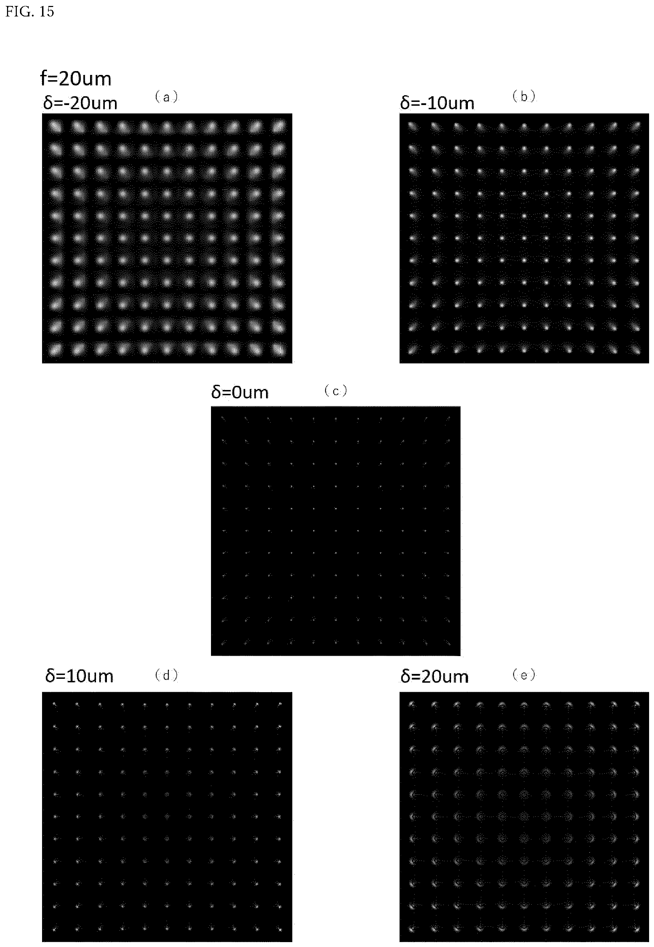

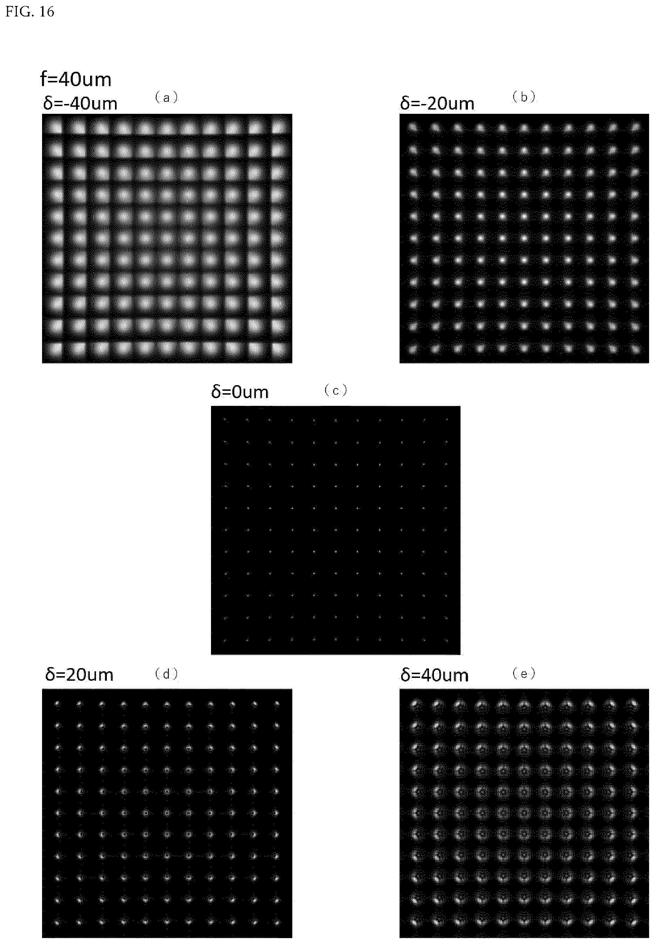

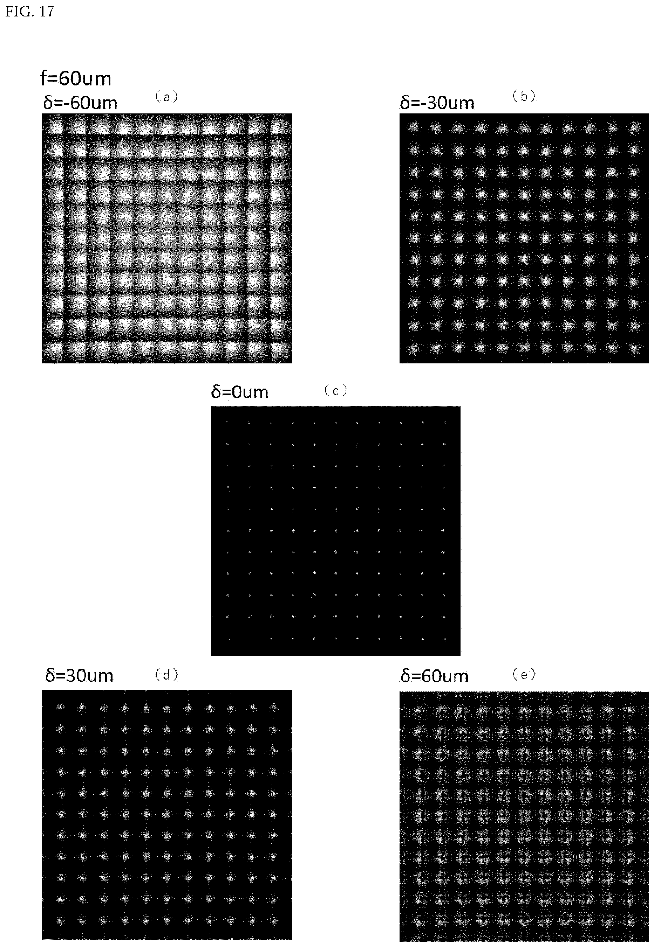

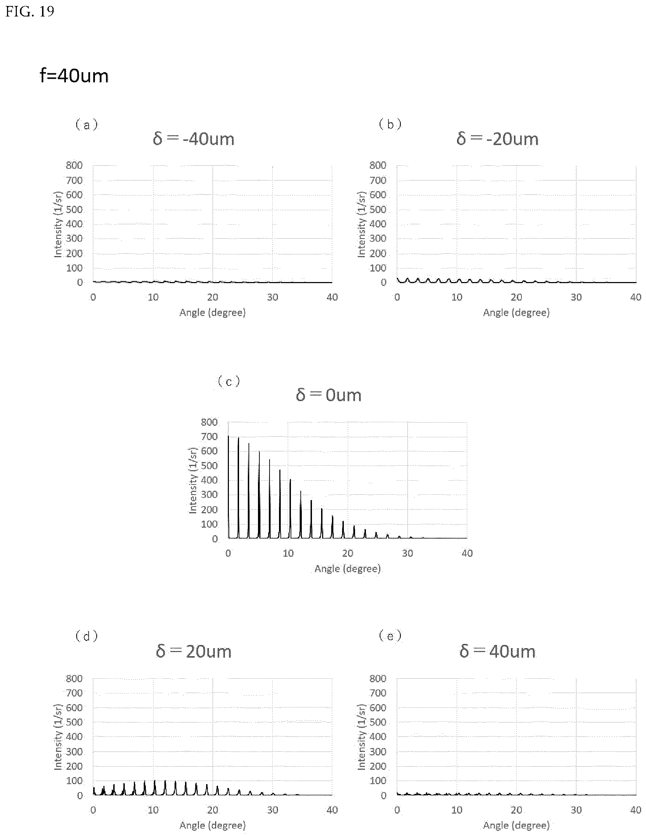

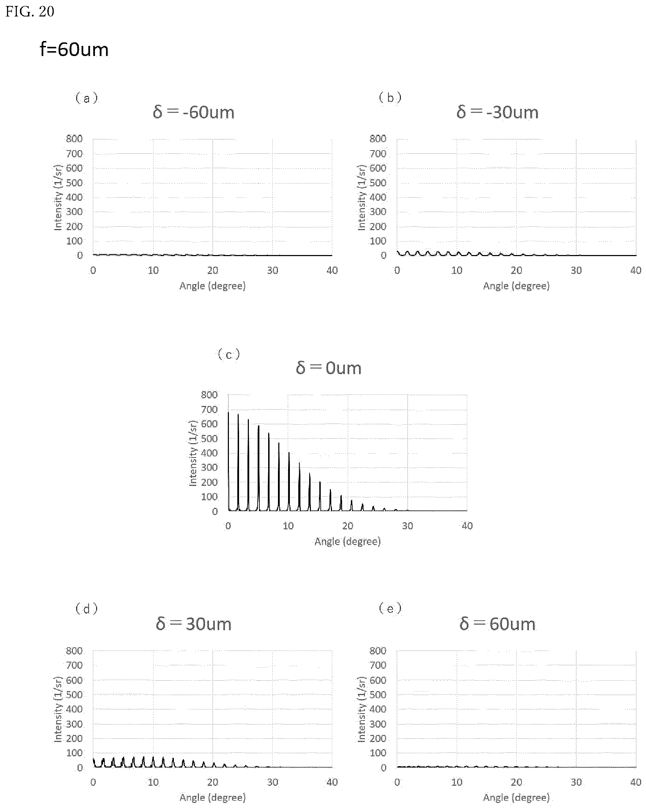

The emitting unit 1 was a singular light source that emits light which has a wavelength of 940 nm ($\lambda$ = 0.94) and which is Gaussian distributed light as illustrated in FIG. 7. The optical element 2 had the plurality of lenses 21 arranged tetragonally at the pitch $P_1$ that is 30 $\mu$m ($P_1$ = 30) as illustrated in FIG. 1, and has the refractive index of 1.5. Moreover, the lens surface was made as rotationally symmetric in such a way that the curvature becomes consistent in the x-axis direction and in the y-axis direction. Furthermore, as illustrated in FIG. 12 to FIG. 14, three kinds of the lenses 21 that have respective focal distances f which are 20 $\mu$m, 40 $\mu$m and 60 $\mu$m were applied. Note that n in the formula 3 was set to be 2. FIG. 15 to FIG. 23 illustrate simulation results using the optical simulation software BeamPROP (available from Synopsys Inc.). Such a simulation was a 3D calculation result that has the depthwise direction in FIG. 1 taken into consideration.

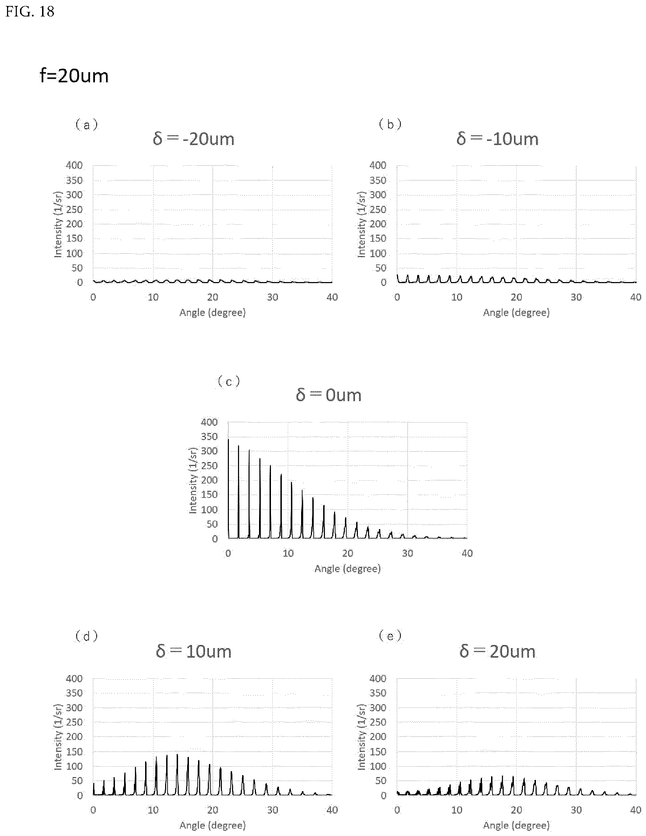

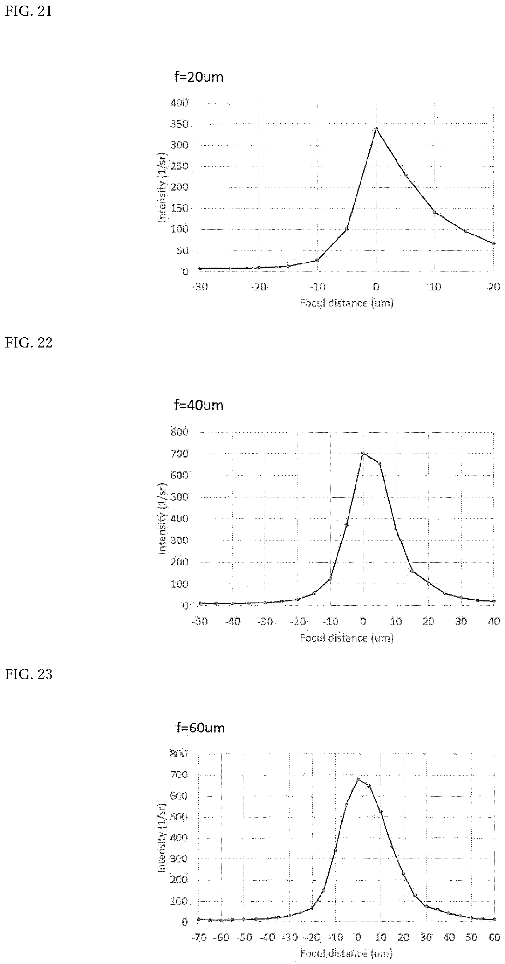

FIG. 15 to FIG. 17 each illustrate a projection image ahead from the optical element by 50 cm when $\delta$ of the formula 3 was changed variously for the three kinds of the lenses. Moreover, FIG. 18 to FIG. 20 each show a light intensity distribution when $\delta$ of the formula 3 was changed variously for the three kinds of the lenses. Furthermore, FIG. 21 to FIG. 23 each illustrate the maximum light intensity in each light intensity distribution relative to the value of $\delta$ for the three kinds of the lenses.

Note that the horizontal axis in respective parts (a) and (b) of FIG. 18 to FIG. 20 represents a light distribution angle, and the vertical axis therein represents a light intensity at a far field when the power of the light source is defined as 1. Moreover, the horizontal axis in respective parts (c) of FIG. 18 to FIG. 20 represents $\delta$, and the vertical axis therein represents a light intensity at a far field when the power of the light source is defined as 1.

In view of the simulation results, it becomes clear that the optical element 2 that satisfies the formula 1 has a clear peak, and has a large light intensity at the peak in comparison with a case in which the formula A is satisfied. Moreover, it also becomes clear that, when the formula 2 is satisfied, the light intensity at the peak becomes the maximum.

[Third Simulation]

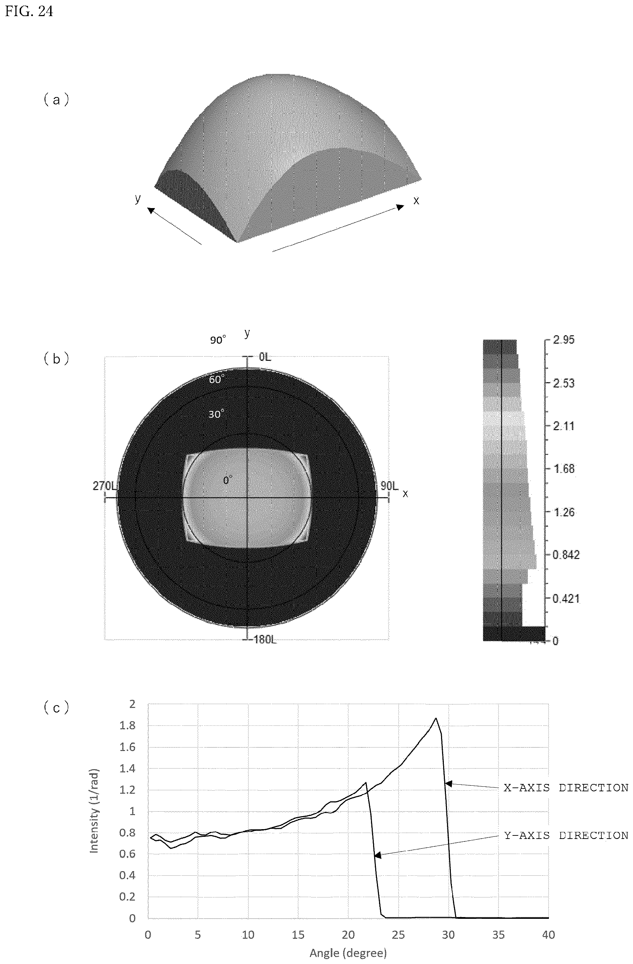

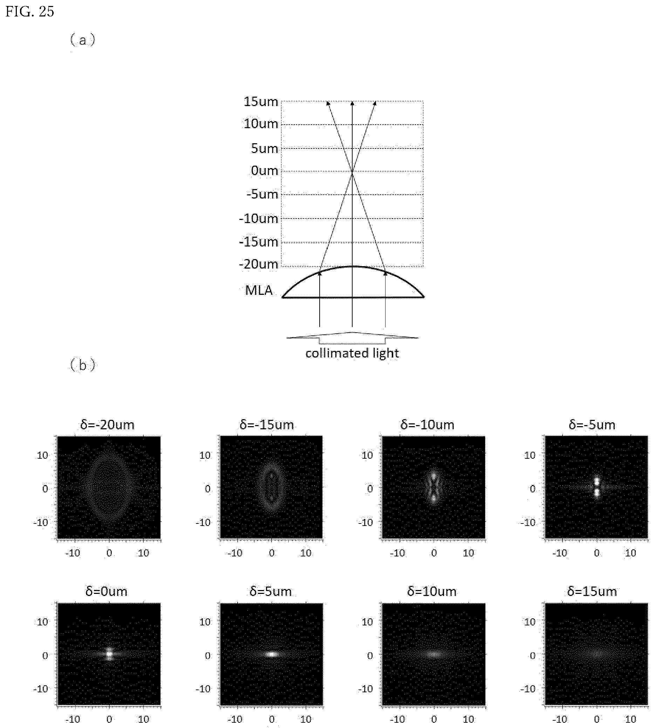

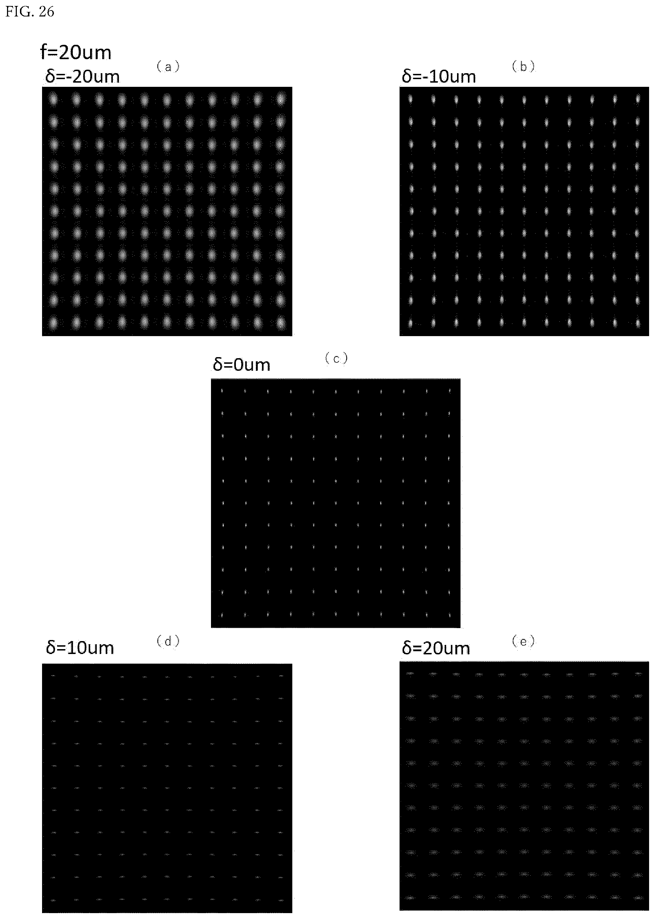

The emitting unit 1 was a singular light source that emits light which has a wavelength of 940 nm ($\lambda$ = 0.94) and which is Gaussian distributed light as illustrated in FIG. 7. The optical element 2 had the plurality of lenses 21 arranged tetragonally at the pitch $P_1$ that is 30 $\mu$m ($P_1$ = 30) as illustrated in FIG. 1, and had the refractive index of 1.5. Moreover, the shape of the lens 21 was a square in a planar view with each side being 30 $\mu$m, and with a height being 16.26 $\mu$m as illustrated in part (a) of FIG. 24. Furthermore, the lens surface was made as an aspheric surface that is not rotationally symmetric in such a way that the curvature differs in the x-axis direction and in the y-axis direction. Part (b) of FIG. 24 is a projection drawing of a distributed light distribution at a far field when collimated light was caused to enter the optical element. Still further, part (c) of FIG. 24 illustrates a distributed light distribution at a far field relative to an angle in the x-axis direction and in the y-axis direction. Yet still further, as illustrated in FIG. 25, the applied lens 21 had the focal distance f that is 20 $\mu$m. Part (b) of FIG. 25 is a projection drawing of outgoing light when collimated light was caused to enter the lens 21. Note that the way of concentrating lights differs in the x-axis direction and in the y-axis direction, but a point where the lights were concentrated maximally was taken as a focal point position (0 $\mu$m). Moreover, n in the formula 3 was set to be 2. FIG. 26 to FIG. 29 each illustrate simulation results using the optical simulation software BeamPROP (available from Synopsys Inc.). Such a simulation was a 3D calculation result that has the depthwise direction in FIG. 1 taken into consideration.

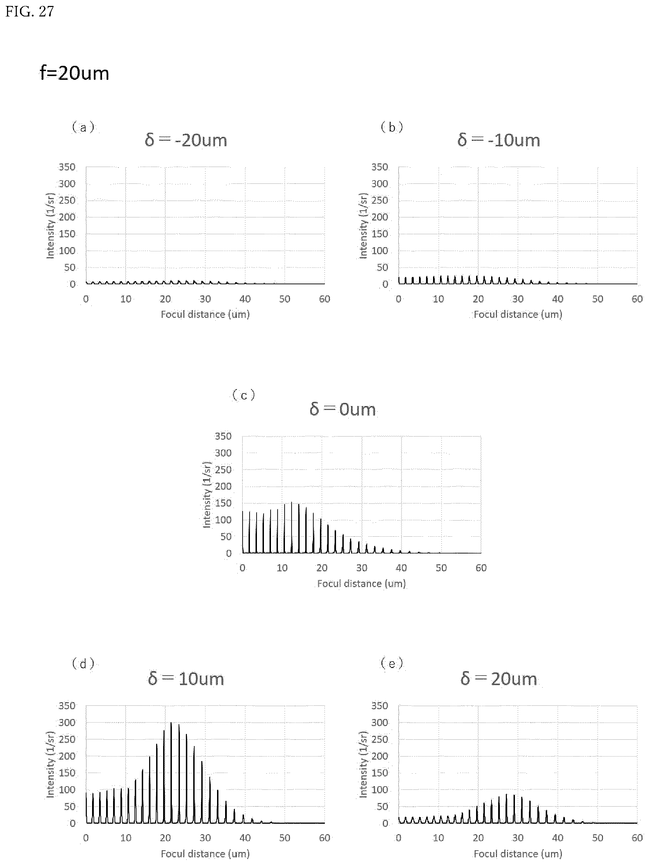

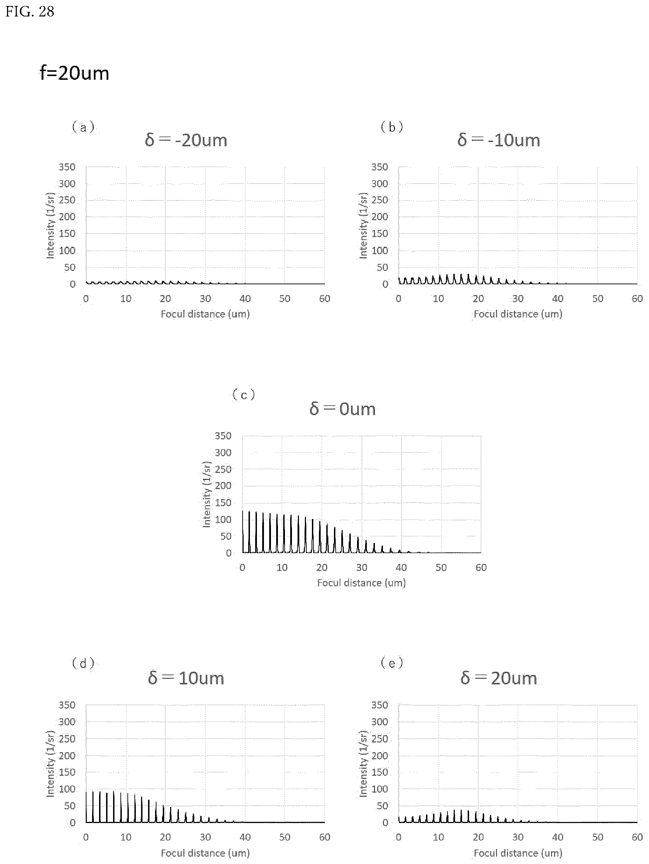

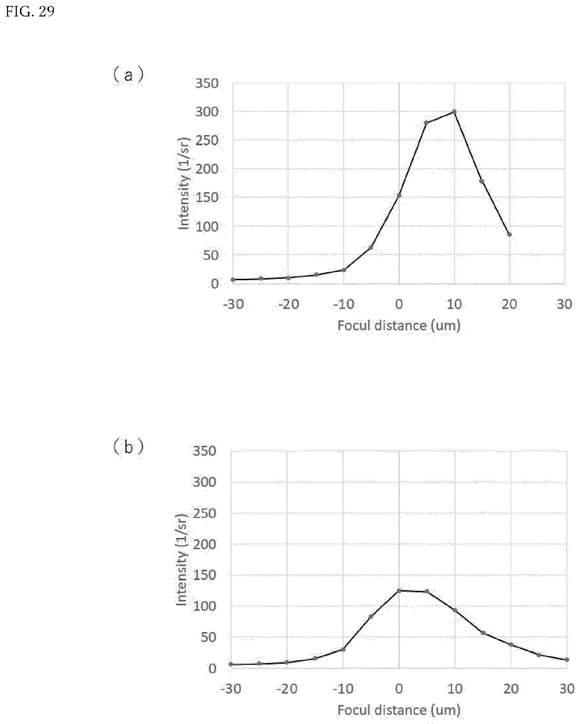

FIG. 26 illustrates a projection image ahead from the optical element by 50 cm when $\delta$ of the formula 3 was changed variously. Moreover, FIG. 27 illustrates a light intensity distribution in the x-axis direction when $\delta$ of the formula 3 was changed variously. Furthermore, FIG. 28 illustrates a light intensity distribution in the y-axis direction when $\delta$ of the formula 3 was changed variously. Still further, FIG.29 illustrates the maximum light intensity of each light intensity distribution in the x-axis direction and in the y-axis direction relative to the value of $\delta$.

Note that the horizontal axis in FIG. 26 to FIG. 28 represents a light distribution angle, and the vertical axis therein represents a light intensity at a far field when the power of the light source was defined as 1. Moreover, the horizontal axis in FIG. 29 represents $\delta$, and the vertical axis therein represents a light intensity at a far field when the power of the light source was defined as 1.

In view of the simulation results, it becomes clear that the optical element 2 that satisfies the formula 3 has a clear peak, and has a large light intensity at the peak in comparison with a case in which the formula A is satisfied. Moreover, it also becomes clear that, since the nonrotationally symmetric lens that has a different curvature in the x-axis direction and in the y-axis direction were applied, the sufficient light intensity can be accomplished as far as the formula 3 is satisfied although the position where the light intensity of the peak becomes the maximum differs in the x-axis direction and in the y-axis direction.

[Optical Element Producing Method]

A producing method of the optical element will be described. The lenses 21 of the optical element 2 can be produced by any scheme, but for example, can be produced by imprinting. More specifically, a material of the lenses 21 is applied on a substrate 25 at a predetermined film thickness by conventionally well-known scheme like spin coating (applying process). The material is not limited to any particular one as far as the lens 21 that allows light with a wavelength λ to pass therethrough can be formed, and for example, polydimethylsiloxane (PDMS) is applicable.

Next, a mold that has an inverted pattern of a pattern for the lenses 21 arranged periodically is prepared, and the mold is pressed against the material applied on the substrate 25, thereby transferring the pattern (imprinting process).

Since the optical element that has a small variability in the focal point positions 9 of the lenses 21 can be produced by the above-described method, an error in the distance $L_1$ can be reduced.

[Pitch in Emitting Unit]

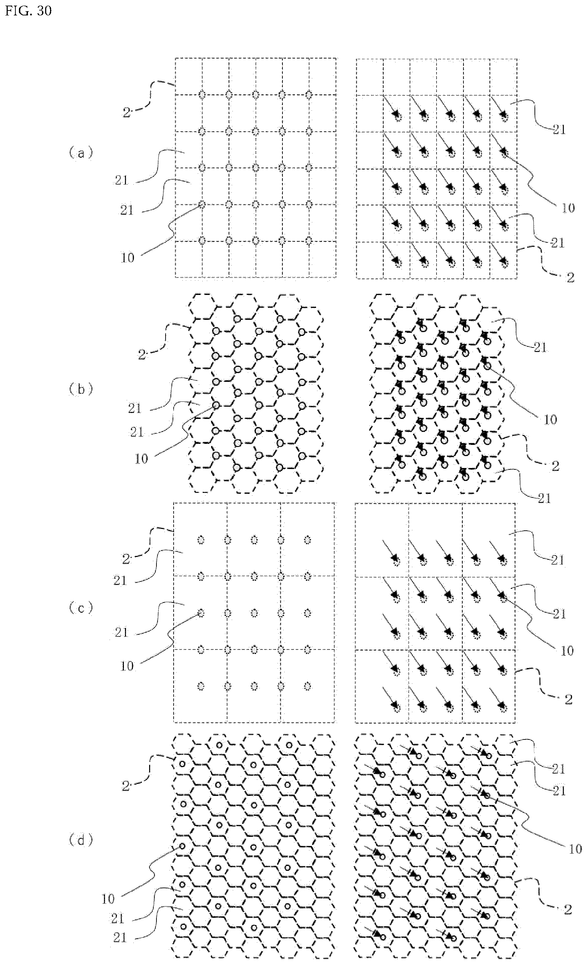

When the emitting unit 1 includes the plurality of light sources 10, even if each light source 10 and the optical element 2 are relatively moved so as to be in parallel with each other, it is necessary to accomplish a placement in such a way that the number of the light sources 10 to each lens 21 of the optical element 2 becomes consistent in a planar view. More specifically, when m is defined as a natural number that is equal to or greater than 1, as for the emitting unit, it is preferable that the plurality of light sources should be arranged regularly by, relative to the periodic direction of any one of the lenses 21 of the optical element, m times or 1/m times of the period. In other words, it is preferable that the light sources 10 of the emitting unit 1 should be arranged regularly by a pitch $mP_k$ or $P_k/m$ relative to the direction in which the lenses 21 of the optical element 2 take the pitch $P_k$. In particular, a pitch $mP_1$ or $P_1/m$ is preferable. Parts (a) and (b) of FIG. 30 each illustrate a case in which the pitch of the light sources 10 is made consistent with the pitch $P_1$ of the lenses 21 of the optical element 2, where m = 1. Moreover, part (c) of FIG. 30 illustrates a case in which the pitch of the light sources 10 is set to be 1/2 of the pitch $P_1$ of the lenses 21 of the optical element 2, i.e., $P_1/2$, where m = 2. Furthermore, part (d) of FIG. 30 illustrates a case in which the pitch of the light sources 10 is set to be twice as much as the pitch $P_1$ of the lenses 21 of the optical element 2, i.e., $2P_1$, where m = 2.

Note that when the emitting unit 1 has the light sources 10 arranged hexagonally, it is preferable that the planar shape of the lens 21 of the optical element should be formed in a rectangular shape, a ratio between the short side of such a rectangular shape and the long side thereof should be set to be $P_1:P_2 = 1:\sqrt{3}$, and the pitch of the light source 10 should be set to be $mP_1$ or $P_1/m$ since the number of the optical elements 10 relative to each lens 21 becomes uniform. Moreover, in such a case, in order to satisfy the formula 1 for the smallest pitch $P_1$ (the length of the short side of the rectangular shape) and for the second smallest pitch $P_2$ (the length of the long side of the rectangular shape), with $P_2 = \sqrt{3}P_1$ being taken into consideration, it is preferable that the distance $L_1$ between the emitting unit 1 and the optical element 2 should satisfy the following formula 4, and more preferably, should satisfy the following formula 5.

[Mathematical Expression 14]

$$\frac{3\,n\,P_1^{2}}{2\lambda} - f < L_1 < \frac{3\,n\,P_1^{2}}{2\lambda} + f \qquad \text{Formula 4}$$

[Mathematical Expression 15]

$$L_1 = \frac{3\,n\,P_1^{2}}{2\lambda} \qquad \text{Formula 5}$$

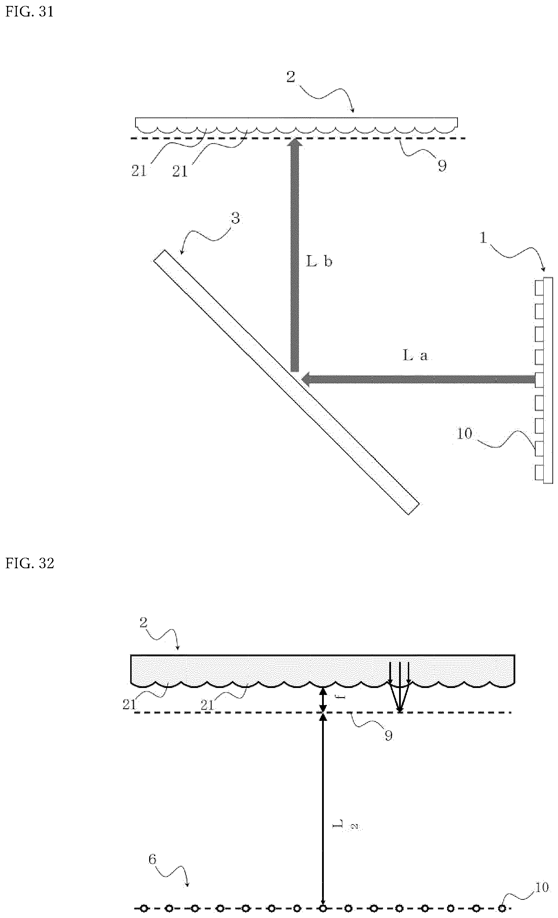

Moreover, it is unnecessary that light from the emitting unit 1 is directly emitted to the optical element 2, and as illustrated in FIG. 31, the light from the emitting unit 1 may be emitted through a mirror 3 that reflects the light. In this case, the distance $L_1$ between the emitting unit 1 and the focal point position 9 of the optical element 2 means a substantial distance (the distance of an optical path). Hence, the distance $L_1$ in case of FIG. 32 becomes, as indicated by arrows, La + Lb that is the sum of the distance La from the emitting unit 1 to the mirror 3 and the distance Lb from the mirror 3 to the focal point position 9 of the optical element 2. Accordingly, the distance L can be adjusted by the mirror 3. Moreover, the direction of the light from the light source can be also adjusted.

Moreover, the optical element 2 according to the present disclosure is applicable to emit a dot pattern, but is also utilizable for a diffuser application.

As for a first scheme to utilize the optical element 2 as a diffuser, as illustrated in FIG. 32, diffuser emitting units 6 that includes the plurality of light sources 10 which emits lights with a wavelength $\lambda$ and which is arranged as same as those of the emitting unit 1 utilized for emitting a dot pattern is prepared. Moreover, it is appropriate that a distance $L_2$ between the diffuser emitting unit 6 and the focal point position 9 of the optical element 2 is made so as not to satisfy the formula 1. In other words, it is appropriate if the distance $L_2$ satisfies the following formula $\alpha$.

[Mathematical Expression 16]

$$\frac{(n-1)P_k^2}{2\lambda} + f < L_2 < \frac{nP_k^2}{2\lambda} - f \qquad \text{Formula } \alpha$$

Accordingly, it becomes clear that, as shown in the above-described first to third simulations, the width of each peak spreads, and the variability in the light intensity is reduced.

Note that it is more preferable that the distance $L_2$ should be further similar to the following formula $\beta$.

[Mathematical Expression 17]

$$L_2 = \frac{(2n-1)P_k^2}{4\lambda} \qquad \text{Formula } \beta$$

The diffuser formed as described above can be utilized in combination with an optical system device that emits the above-described dot pattern. Hence, for an object at long distance, with the intensity of the emitted light being assured by the dot pattern, the distance, and the shape, etc., can be measured, and for an object at short distance, the distance, and the shape, etc., can be further precisely measured by emitting thereto the light from the diffuser.

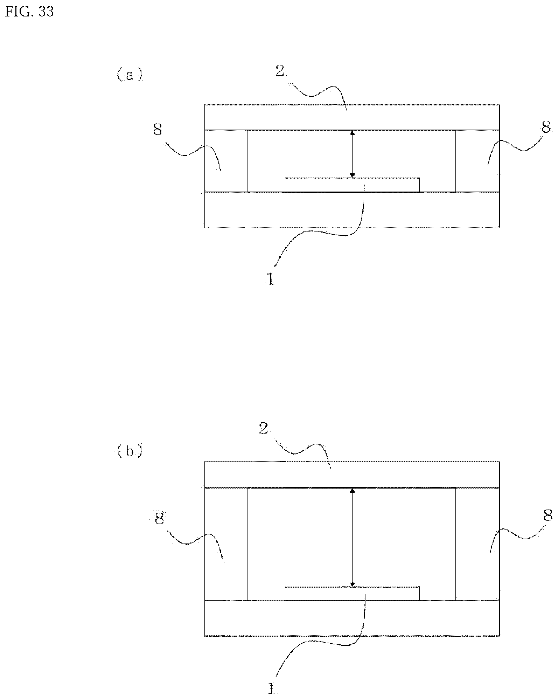

Moreover, as illustrated in FIG. 33, the optical system device according to the present disclosure may further include distance adjusting means 8 for adjusting a distance between the emitting unit 1 and the optical element 2. This facilitates the adjustment of the distance $L_1$ between the emitting unit 1 and the focal point position 9 of the optical element 2. Furthermore, by adjusting the distance $L_1$ between the emitting unit 1 and the focal point position 9 of the optical element 2, the optical system device of the present disclosure can be utilized so as to change light emission between the emission of a dot pattern and the emission as a diffuser. As for the distance adjusting means 8, for example, a conventionally well-known actuator may be applied.

REFERENCE SIGNS LIST

| | |
|---|---|
| 1 | Emitting unit |
| 2 | Optical element |
| 3 | Mirror |
| 6 | Diffuser emitting unit |
| 8 | Distance adjusting means |
| 9 | Focal point position |
| 10 | Light source |
| 21 | Lens |

**Claims**

1. An optical system device comprising:

an optical element that comprises a plurality of lenses through which light with a wavelength $\lambda$ passes and which is arranged periodically; and
an emitting unit that comprises a light source which emits the light with the wavelength $\lambda$ to the plurality of lenses, wherein when a focal distance of the lens is defined as f, n is defined as a natural number that is equal to or greater than one, and a dimension of a k-th pitch (where k is a natural number that is equal to or greater than one) from the smallest pitch among the pitches of the lenses is defined as $P_k$, for equal to or greater than any

one pitch $P_k$, a distance $L_1$ between the emitting unit and a focal point position of the optical element satisfies the following formula 1.

[Mathematical Expression 1]

$$\frac{n\,P_k^{\,2}}{2\lambda} - f < L_1 < \frac{n\,P_k^{\,2}}{2\lambda} + f \qquad \text{Formula 1}$$

2. The optical system device according to claim 1, wherein the distance $L_1$ satisfies the following formula 2.

[Mathematical Expression 2]

$$L_1 = \frac{n\,P_k^{\,2}}{2\lambda} \qquad \text{Formula 2}$$

3. The optical system device according to claim 1, wherein the formula 1 is satisfied for the smallest pitch $P_1$.

4. The optical system device according to claim 3, wherein the formula 1 is satisfied for the second smallest pitch $P_2$.

5. An optical system device comprising:

an optical element that comprises a plurality of lenses through which light with a wavelength $\lambda$ passes and which is arranged periodically; and

an emitting unit that comprises a light source which emits the light with the wavelength $\lambda$ to the plurality of lenses, wherein when a focal distance of the lens is defined as f, n is defined as a natural number that is equal to or greater than one, and a dimension of a k-th pitch (where k is a natural number that is equal to or greater than one) from the smallest pitch among the pitches of the lenses is defined as $P_k$, for equal to or greater than any one pitch $P_k$, a distance $L_2$ between the emitting unit and a focal point position of the optical element satisfies the following formula $\alpha$.

[Mathematical Expression 3]

$$\frac{(n-1)P_k^{\,2}}{2\lambda} + f < L_2 < \frac{n\,P_k^{\,2}}{2\lambda} - f \qquad \text{Formula } \alpha$$

6. The optical system device according to any one of claims 1 to 5, further comprising distance adjusting means for adjusting a distance between the optical element and the emitting unit.

FIG. 1

FIG. 2

FIG. 3

A: （1） 0.0482  B: （2） （3） 0.02804  C: （4） （6） 0.02835

D: （5） 0.112  E: （7） （9） 0.02855  F （8） （1 0） 0.0497

FIG. 4

（a）

0.0271

（b）

A:B:C:D:E:F=2:1:1:1:1:1    0.03      A:B:C:D:E:F=1:2:1:1:1:1    0.024     A:B:C:D:E:F=1:1:2:1:1:1    0.0233

A:B:C:D:E:F=1:1:1:2:1:1    0.0389    A:B:C:D:E:F=1:1:1:1:2:1    0.0233    A:B:C:D:E:F=1:1:1:1:1:2    0.0285

（c）

A:B:C:D:E:F=5:1:1:1:1:1    0.0354    A:B:C:D:E:F=1:1:1:5:1:1    0.0608    A:B:C:D:E:F=1:1:1:1:1:5    0.0343

FIG. 5

（a）

（b）

FIG. 6

FIG. 7

FIG. 8

（ a ）

（ b ）

FIG. 9

# f=20um

（a）

## δ=-20um

（b）

## δ=0um

（c）

FIG. 10

f=40um

（a） δ=-40um

（b） δ=0um

（c）

FIG. 11

f=60um

（a）

δ=-60um

（b）

δ=0um

（c）

FIG. 12

(a)

(b)

δ=-20um        δ=-15um        δ=-10um        δ=-5um

δ=0um        δ=5um        δ=10um        δ=15um

FIG. 13

（a）

（b）

FIG. 14

(a)

(b)

FIG. 15

FIG. 16

f=40um

δ=-40um （a）

δ=-20um （b）

δ=0um （c）

δ=20um （d）

δ=40um （e）

FIG. 17

f=60um

δ=-60um （a）

δ=-30um （b）

δ=0um （c）

δ=30um （d）

δ=60um （e）

FIG. 18

f=20um

(a) δ=-20um

(b) δ=-10um

(c) δ=0um

(d) δ=10um

(e) δ=20um

FIG. 19

f=40um

(a) δ＝-40um

(b) δ＝-20um

(c) δ＝0um

(d) δ＝20um

(e) δ＝40um

FIG. 20

## f=60um

(a)

### δ＝-60um

(b)

### δ＝-30um

(c)

### δ＝0um

(d)

### δ＝30um

(e)

### δ＝60um

FIG. 21

f=20um

FIG. 22

f=40um

FIG. 23

f=60um

FIG. 24

（a）

（b）

（c）

FIG. 25

（a）

（b）

FIG. 26

f=20um

δ=-20um (a)

δ=-10um (b)

δ=0um (c)

δ=10um (d)

δ=20um (e)

FIG. 27

## f=20um

（a）
### δ＝-20um

（b）
### δ＝-10um

（c）
### δ＝0um

（d）
### δ＝10um

（e）
### δ＝20um

FIG. 28

## f=20um

(a)

### δ=-20um

(b)

### δ=-10um

(c)

### δ=0um

(d)

### δ=10um

(e)

### δ=20um

FIG. 29

（a）

（b）

FIG. 30

FIG. 31

2

21   21

9

3

L b

1

L a

10

FIG. 32

2

21   21

9

f

L₂

6

10

FIG. 33

(a)

(b)

## INTERNATIONAL SEARCH REPORT

| International application No. |
|---|
| **PCT/JP2022/031411** |

**A. CLASSIFICATION OF SUBJECT MATTER**

*G02B 3/00*(2006.01)i; *F21V 5/00*(2018.01)i; *F21V 5/04*(2006.01)i; *F21V 13/02*(2006.01)i; *F21V 14/00*(2018.01)i; *G01S 7/481*(2006.01)i; *H01S 5/022*(2021.01)i; *F21Y 115/30*(2016.01)n
FI: G02B3/00 A; F21V5/00 320; F21V5/00 530; F21V5/04 350; F21V13/02 400; F21V14/00 200; G01S7/481 A; H01S5/022; F21Y115:30

According to International Patent Classification (IPC) or to both national classification and IPC

**B. FIELDS SEARCHED**

Minimum documentation searched (classification system followed by classification symbols)

G02B3/00; F21V5/00; F21V5/04; F21V13/02; F21V14/00; G01S7/481; H01S5/022; F21Y115/30

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US 11085609 B1 (HIMAX TECHNOLOGIES LIMITED) 10 August 2021 (2021-08-10) column 1, lines 12-59, column 2, lines 16-29, column 3, line 15 to column 5, line 3, fig. 1-6 | 1, 3-6 |
| A | | 2 |
| X | JP 2018-511034 A (HEPTAGON MICRO OPTICS PTE. LTD.) 19 April 2018 (2018-04-19) paragraphs [0027]-[0051], [0196]-[0211], fig. 1-3 | 1, 3, 5-6 |
| A | | 2, 4 |
| X | WO 2017/131585 A1 (HEPTAGON MICRO OPTICS PTE. LTD.) 03 August 2017 (2017-08-03) specification, p. 7, line 19 to p. 8, line 20, p. 28, line 20 to p. 32, line 25, fig. 1-3 | 1, 3, 5-6 |
| A | | 2, 4 |

✓ Further documents are listed in the continuation of Box C.      ✓ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **21 September 2022** | **11 October 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/031411**

| C. | DOCUMENTS CONSIDERED TO BE RELEVANT | | |
|---|---|---|
| Category* | Citation of document, with indication, where appropriate, of the relevant passages | Relevant to claim No. |
| X | WO 2020/222704 A1 (AMS SENSORS ASIA PTE. LTD.) 05 November 2020 (2020-11-05) specification, p. 5, line 23 to p. 9, line 7, fig. 1 | 1, 3, 5-6 |
| A | | 2, 4 |
| P, X | WO 2021/229848 A1 (SCIVAX CORPORATION) 18 November 2021 (2021-11-18) claims | 1, 3-6 |
| P, X | WO 2021/230324 A1 (SCIVAX CORPORATION) 18 November 2021 (2021-11-18) claims | 1, 3-6 |

Form PCT/ISA/210 (second sheet) (January 2015)

43

**INTERNATIONAL SEARCH REPORT**
Information on patent family members

International application No.

**PCT/JP2022/031411**

| Patent document cited in search report | | | Publication date (day/month/year) | Patent family member(s) | | | Publication date (day/month/year) |
|---|---|---|---|---|---|---|---|
| US | 11085609 | B1 | 10 August 2021 | JP | 2022-121366 | A | |
| | | | | paragraphs [0002]-[0006], [0008]-[0009], [0022]-[0033], fig. 1-6 | | | |
| | | | | KR | 10-2022-0114457 | A | |
| | | | | CN | 114941827 | A | |
| | | | | EP | 4040217 | A1 | |
| JP | 2018-511034 | A | 19 April 2018 | US | 9273846 | B1 | |
| | | | | column 2, line 41 to column 5, line 28, column 9, line 51 to column 11, line 19, fig. 1-3 | | | |
| | | | | WO | 2016/122404 | A1 | |
| | | | | TW | 201638555 | A | |
| | | | | CN | 107429993 | A | |
| | | | | KR | 10-2017-0126872 | A | |
| WO | 2017/131585 | A1 | 03 August 2017 | US | 2019/0049097 | A1 | |
| | | | | CN | 108779905 | A | |
| | | | | TW | 201739131 | A | |
| WO | 2020/222704 | A1 | 05 November 2020 | CN | 113767249 | A | |
| | | | | TW | 202107008 | A | |
| | | | | US | 2022/0205611 | A1 | |
| | | | | DE | 112020002161 | T5 | |
| WO | 2021/229848 | A1 | 18 November 2021 | (Family: none) | | | |
| WO | 2021/230324 | A1 | 18 November 2021 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006500621 A

- WO 2017131585 A

**Non-patent literature cited in the description**

- **H. HAMAM ; LAU ARRAY ILLUMINATOR.** *Applied Optics,* 10 May 2004, vol. 43 (14), 2888-2894